# EUROPEAN PATENT SPECIFICATION

(11) **EP 2 624 455 B1**
(45) Date of publication and mention of the grant of the patent: **25.12.2019**
(21) Application number: 11829303.4
(22) Date of filing: 29.09.2011
(51) Int. Cl.: H03K 19/0185, H03K 17/16, H03K 17/687

(54) **LEVEL SHIFT CIRCUIT**
PEGELSCHIEBERSCHALTUNG
CIRCUIT DE DÉCALAGE DE NIVEAU

(30) Priority: 30.09.2010 JP 2010222359
(43) Date of publication of application: 07.08.2013
(73) Proprietor: Fuji Electric Co., Ltd., Kawasaki-shi 210-9530 (JP)
(72) Inventor: AKAHANE, Masashi, Kawasaki-shi Kanagawa 210-9530 (JP)
(74) Representative: Erny, Tobias
(86) International application number: PCT/JP2011/072434
(87) International publication number: WO 2012/043750

(56) References cited:
- DE-A1- 19 636 753
- JP-A- 9 200 017
- JP-A- 9 200 020
- JP-A- 2000 252 809
- JP-A- 2005 051 821
- US-A1- 2003 210 081

## Description

### Technical Field

The present invention relates to a level shift circuit 2, 2-1, 2-2 that transmits an input primary side system signal to a secondary side system operating on an operating voltage differing from the operating voltage of the input primary side.

### Background Art

A level shift circuit 2, 2-1, 2-2 is used in a half-bridge drive circuit to which is applied a power source voltage of a high voltage system power source, and the like, in order to drive a high voltage side switching element with a low voltage system signal as explained for example in document US 2003/0210081 A1.

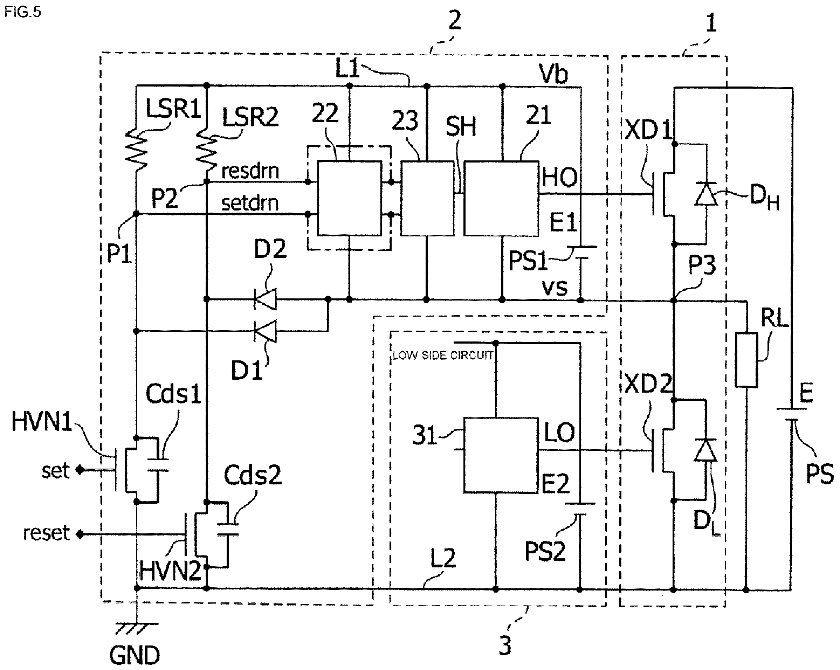

One example of a half-bridge drive circuit using a level shift circuit 2, 2-1, 2-2 is shown in PTL 1. Hereafter, a description will be given of this kind of heretofore known level shift circuit 2, 2-1, 2-2, referring to Fig. 5, which shows a half-bridge drive circuit using the heretofore known level shift circuit 2, 2-1, 2-2.

In Fig. 5, an output circuit 1 includes serially connected switching elements XD1 and XD2 configuring a half-bridge, and an output voltage E of a high voltage power source PS is applied to both ends of the half-bridge. An element such as, for example, an n-channel or p-channel MOS transistor, or a p-type or n-type IGBT (Insulated Gate Bipolar Transistor), is used for the high side switching element XD1, while an element such as, for example, an n-channel MOS transistor or an n-type IGBT is used for the low side switching element XD2. Herein, it is assumed that n-channel MOS transistors or n-type IGBTs are applied as the switching elements XD1 and XD2. Diodes D_{H} and D_{L} (parasitic diodes or free wheeling diodes) are connected in anti-parallel to the switching elements XD1 and XD2 respectively.

A high side drive unit 2 includes the level shift circuit 2, 2-1, 2-2, a high side driver 21 that receives the output of the level shift circuit 2, 2-1, 2-2 and controls the turning on and off of the switching element XD1, and a power source PS1.

The level shift circuit 2, 2-1, 2-2 is a portion of the high side drive unit 2 excluding the high side driver 21 and power source PS1. That is, the level shift circuit 2, 2-1, 2-2 is configured of a first series circuit formed of a resistor LSR1 and an n-channel MOS transistor HVN1, a second series circuit formed of a resistor LSR2 and an n-channel MOS transistor HVN2, a latch malfunction protection circuit 22, a latch circuit 23, and diodes D1 and D2. The latch malfunction protection circuit 22 is such that one input terminal thereof is connected to a series connection point (a first connection point) P1 of the first series circuit, while the other input terminal is connected to a series connection point (a second connection point) P2 of the second series circuit.

The level shift circuit 2, 2-1, 2-2 inputs an output signal SH of the latch circuit 23 into the high side driver 21 as a level shifted signal.

The output terminal of the high side driver 21 is connected to the gate terminal of the high side switching element XD1. Also, the negative side (low voltage side) power source terminal of each of the latch malfunction protection circuit 22, latch circuit 23, high side driver 21, and power source PS1 is connected to a third connection point P3, which is a series connection point of the switching elements XD1 and XD2. An output voltage E1 of the power source PS1 is applied to the latch malfunction protection circuit 22, latch circuit 23, and high side driver 21.

The first series circuit formed of the resistor LSR1 and transistor HVN1 and the second series circuit formed of the resistor LSR2 and transistor HVN2 are each connected between a power source line L1 (whose voltage is taken to be Vb) connected to the positive side (high voltage side) terminal of the power source PS1 and a ground (GND) line L2.

A set signal (set) and a reset signal (reset), which are signals input into the level shift circuit 2, 2-1, 2-2, are input into the gates of the n-channel MOS transistors HVN1 and HVN2 respectively. The set signal (set) and reset signal (reset) are low voltage system signals.

The set signal (set) is a signal that indicates the timing of the start of an on-period (the end of an off-period) of the high side switching element XD1, while the reset signal (reset) is a signal that indicates the timing of the start of an off-period (the end of an on-period) of the switching element XD1.

The diodes D1 and D2 are such that the anodes thereof are both connected to the third connection point P3, while the cathodes are connected to the first connection point P1 and second connection point P2 respectively. The diodes D1 and D2 are provided with an object of clamping so that the voltages of level shift drain signals (setdrn, resdrn) output from the first and second connection points P1 and P2 do not reach or exceed a voltage VS of the third connection point P3, that is, an object of preventing an overvoltage from being input into the latch malfunction protection circuit 22.

A low side drive unit 3 includes a low side driver 31 that controls the turning on and off of the low side switching element XD2 and a power source PS2 that applies a power source voltage E2 to the low side driver 31. The low side driver 31 amplifies an input signal, and inputs the amplified signal into the gate terminal of the switching element XD2. The switching element XD2 is turned on (has continuity) when the level of the signal input into the low side driver 31 is an "H (High)" level, and turned off (cut off) when the level of the input signal is an "L (Low)" level.

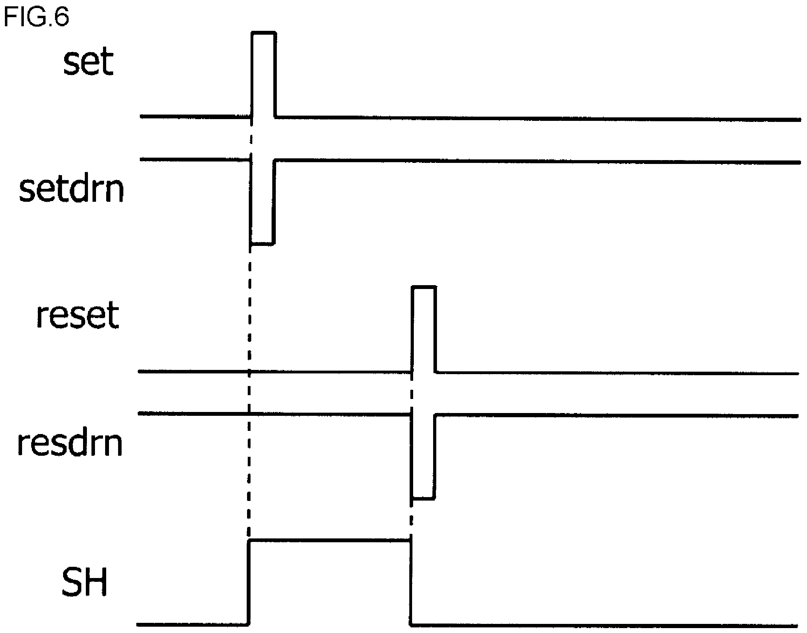

Fig. 6 is a timing chart for illustrating a latch operation using the set and reset signals in the level shift circuit 2, 2-1, 2-2. In the timing chart, as the n-channel MOS transistor HVN1 is turned on when the level of the set signal (set) changes to an "H" level, an "L" level level shift drain signal (setdrn) is output from the first connection point P1. Meanwhile, as the n-channel MOS transistor HVN2 is turned on when the reset signal (reset) changes to an "H" level, an "L" level level shift drain signal (resdrn) is output from the second connection point P2.

Herein, consideration will be given to a condition wherein the level shift drain signals (setdrn and resdrn) are directly input into the latch circuit 23 from the first connection point P1 and second connection point P2 respectively, ignoring the latch malfunction protection circuit 22, as indicated by the chain lines in Fig. 5. In this case, for a period from a point at which the level of the level shift drain signal (setdrn) changes from an "H" level to an "L" level to a point at which the level of the level shift drain signal (resdrn) changes from an "H" level to an "L" level, the latch circuit 23 latches (maintains) an "H" level, and supplies an "H" level signal as the output signal SH to the high side driver 21, because of which, the switching element XD1 is turned on for the latch period by an "H" level signal HO output from the high side driver 21.

The switching elements XD1 and XD2 are turned on and off in a complementary way (when one is turned on, the other is turned off), except in dead time when both are turned off. Further, the voltage VS of the third connection point P3 is essentially a ground voltage when the switching element XD2 is in an on-state, and essentially the output voltage E of the high voltage power source PS when the switching element XD1 is in an on-state.

A load RL is connected between the third connection point P3 and ground line L2, and is driven by power output from the third connection point P3.

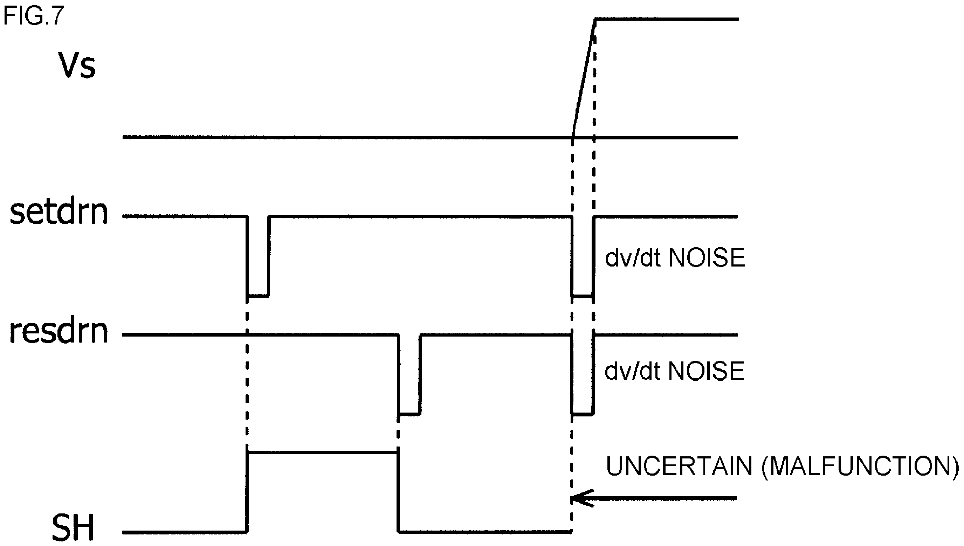

Herein, consideration will be given to when there is a switch from a condition in which the switching element XD2 is in an on-state to a condition in which the switching element XD1 is in an on-state. Accompanying a switch between the two heretofore described conditions, the voltage VS of the connection point P3 rises sharply from the ground voltage to the output voltage E of the high voltage power source PS, as shown in Fig. 7, which is a timing chart for illustrating dv/dt noise.

At this time, when the n-channel MOS transistors HVN1 and HVN2 are both in an off-state, a false signal called dv/dt noise, to be described hereafter, is superimposed on the first and second connection points P1 and P2, and the first and second connection points P1 and P2 both change to an "L" level. When the first and second connection points P1 and P2 both change to an "L" level, there occurs a problem in that the operation of the latch circuit 23 (configured of, for example, a set-reset flip-flop) becomes uncertain, that is, a problem in that it is uncertain whether the switching element XD1 is in an on-state or an off-state. In Fig. 7, the level shift drain signals (setdrn, resdrn) before the voltage VS rises are regular signals, the same as those in Fig. 6. Hereafter, a description will be given of the dv/dt noise.

As the voltage Vb of the power source line L1 is a voltage wherein the output voltage E1, which is a constant voltage, is added to the voltage VS, when the voltage VS rises, the voltage Vb also rises in the same way (the differential coefficients of the two are the same). That is, the voltage Vb applied to the first series circuit formed of the resistor LSR1 and n-channel MOS transistor HVN1 and the second series circuit formed of the resistor LSR2 and n-channel MOS transistor HVN2 increases.

As parasitic capacitors Cds1 and Cds2 exist between the source and drain of the n-channel MOS transistors HVN1 and HVN2 respectively, the change in the voltages of the first and second connection points P1 and P2 cannot keep pace when the voltage Vb changes suddenly, because of which, the difference between the voltage Vb and the voltages of the connection points P1 and P2 increases. Seen from the point of view of the latch circuit 23, this means that the voltages of each input terminal thereof drop simultaneously. The dv/dt noise is generated in this way.

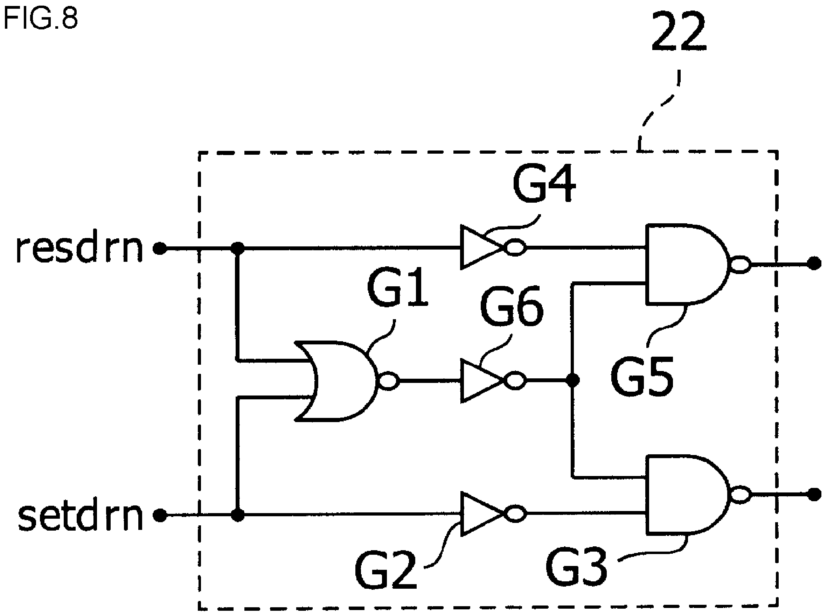

The latch malfunction protection circuit 22 is provided with an object of avoiding the effect of the dv/dt noise. Hereafter, a description will be given of a configuration example and operation of the latch malfunction protection circuit 22, referring to Fig. 8, which is a circuit diagram showing a configuration example of a heretofore known latch malfunction protection circuit.

In the latch malfunction protection circuit 22, one input terminal, into which the level shift drain signal (setdrn) is input, is connected to one input terminal of a NOR circuit G1, and is connected to one input terminal of a NAND circuit G3 via an inverter circuit G2. Also, the other input terminal, into which the level shift drain signal (resdrn) is input, is connected to the other input terminal of the NOR circuit G1, and is connected to one input terminal of a NAND circuit G5 via an inverter circuit G4. Further, the output terminal of the NOR circuit G1 is connected to the other input terminal of the NAND circuit G3 and the other input terminal of the NAND circuit G5 via an inverter G6.

The latch malfunction protection circuit 22 having this kind of configuration operates in the following way. That is, when the dv/dt noise shown in Fig. 7 is generated in the first and second connection points P1 and P2, the dv/dt noise is input into both input terminals of the latch malfunction protection circuit 22. At this time, an "H" level signal is output from each of the inverter circuits G2 and G4, and an "H" level signal is output from the NOR circuit G1. As an "L" level signal is output from the inverter circuit G6 as a result of this, an "H" level signal is output from each of the NAND circuits G3 and G5 as an output signal of the latch malfunction protection circuit 22.

As the latch circuit 23 connected to the latch malfunction protection circuit 22, being configured of a set-reset type flip-flop, or the like, operates in response to a negative logic input signal (carries out a set or reset operation when the input is at an "L" level), the latch circuit 23 does not carry out a latch operation when the "H" level signal is input into a set terminal or reset terminal. That is, the latch circuit 23 maintains the condition previous to the dv/dt noise being generated and the "H" level signal being input, because of which, the switching element XD1 also maintains the previous condition. In this way, the latch malfunction protection circuit 22 functions so as to prevent the latch circuit 23 from falling into an uncertain state (refer to Fig. 7) when the dv/dt noise is generated, that is, so as to protect the latch circuit 23 from malfunction.

### Citation List

### Patent Literature

PTL 1: Japanese Patent No. 3,429,937

### Summary of Invention

### Technical Problem

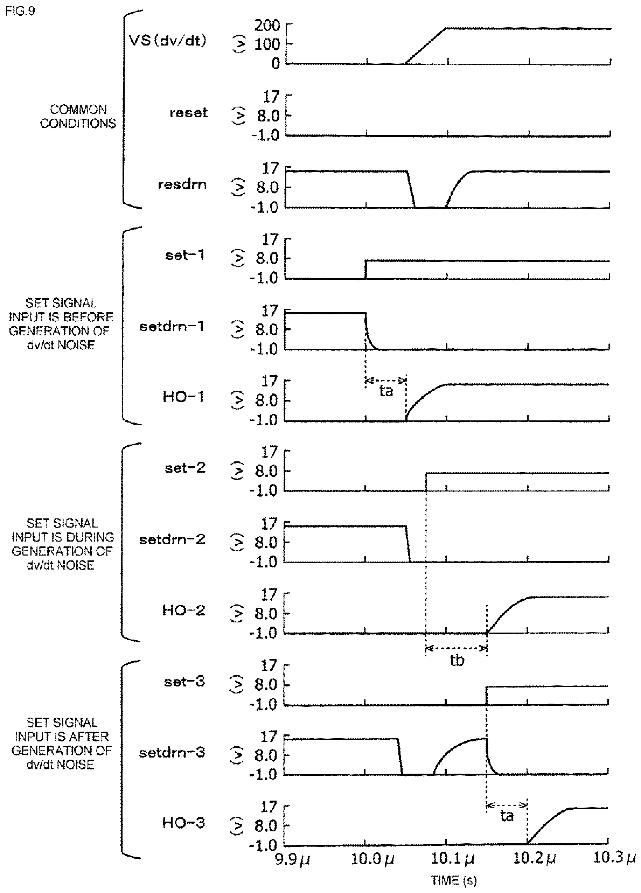

The level shift circuit 2, 2-1, 2-2 is such that, as the n-channel MOS transistor HVN1 is turned on when a set signal (set-1) changes to an "H" level, the level of a level shift drain signal (setdrn-1) changes to an "L" level, as shown in Fig. 9, which is a timing chart for illustrating an operation of the heretofore known level shift circuit 2, 2-1, 2-2 shown in Fig. 5. In this case, as the latch malfunction protection function of the latch malfunction protection circuit 22 does not operate without the reset signal changing, the latch circuit 23 executes a normal latch operation, as a result of which an output signal HO-1 of the high side driver 21 rises, delayed by a unique delay time ta, in the circuits 22 and 23 and the high side driver 21, and the switching element XD1 is turned on. On the switching element XD1 being turned on, an "L" level level shift drain signal (resdrn) is output from the connection point P2 due to the dv/dt noise generated accompanying a rise in the voltage VS. However, this signal (resdrn) is blocked by the latch malfunction protection circuit 22. Consequently, the latch circuit 23 maintains the latch operation.

Note that the voltage VS normally rises when the switching element XD1 is switched from an off-state to an on-state as heretofore described (at this time, the switching element XD2 is switched from an on-state to an off-state), but apart from this, for example, the voltage VS may also rise in dead time (set in order to prevent a shoot-through current from flowing) in which the switching elements XD1 and XD2 are both in an off-state.

That is, when the switching element XD2 is turned off when the condition is such that the switching element XD2 is in an on-state, and current is flowing into the output circuit 1 (when the condition is such that the switching element XD2 is a current sink element), which is a converter component, from the load RL (assumed to be an inductive load wherein the current is not cut off suddenly), current flowing in from the load RL in dead time has no place to go, because of which a floating capacitor in the voltage VS line (the line connected to the connection point P3) is charged by this current, and the voltage VS rises swiftly.

When the voltage VS rises as far as a voltage (the output voltage E of the high voltage power source PS + the forward voltage of the diode D_{H}) that causes the diode D_{H} connected in parallel to the switching element XD1 to be turned on, the diode D_{H} is turned on, and current flows from the load RL into the power source PS via the diode D_{H}.

Herein, a description will be given of a case wherein the level of a set signal (set-2) changes to an "H" level when the voltage VS is rising due to the dead time or the like, that is, a case wherein a period during which the voltage VS rises and a point at which the level of the set signal (set-2) changes to an "H" level coincide.

In this case, the level of the set signal (set-2) changes to an "H" level in a condition wherein each of the level shift drain signals (setdrn-2, resdrn) is at an "L" level due to the dv/dt noise generated accompanying the rise of the voltage VS, that is, a condition wherein the latch malfunction protection circuit 22 is carrying out a protection operation. Because of this, the set signal (set-2) is not transmitted to the latch circuit 23 until the period for which the latch malfunction protection circuit 22 carries out the protection operation is finished (until the period for which the dv/dt noise is generated is finished), and because of this, an output signal HO-2 of the high side driver 21 rises after a long blank period (tb (>ta)).

Furthermore, when the level of a set signal (set-3) changes to an "H" level after the rise of the voltage VS due to the dead time, or the like, is finished, the level of the set signal (set-3) changes to the "H" level in a condition wherein the latch malfunction protection function of the latch malfunction protection circuit 22 is not operating. Therefore, the output signal HO-3 of the high side driver 21 rises, delayed by the unique delay time ta, in the circuits 22 and 23 and the high side driver 21, and the switching element XD1 is turned on at the same time.

As the operation of turning on the switching element XD1 is considerably delayed because of the blank period tb when the voltage VS rises in the dead time period, or the like, as heretofore described, power loss in the diode D_{H} connected in parallel to the switching element XD1 becomes a problem. Because of this, there is a demand for technology that can cause the switching element XD1 to be turned on as quickly as possible.

Therefore, an object of the invention is to provide a level shift circuit 2, 2-1, 2-2 such that it is possible to suppress a delay caused by a circuit counteracting dv/dt noise in an operation of turning on a high side switching element configuring a circuit such as a half-bridge.

### Solution to Problem

In order to achieve the heretofore described object, a level shift circuit 2, 2-1, 2-2 according to the invention is a level shift circuit 2, 2-1, 2-2 that transmits an input signal (set, reset) from a primary side voltage system to a system operating on a secondary side voltage system differing from the primary side voltage system, and includes a series circuit of a first resistor LSR1, LSR1a and first switching element HVN1 connected between a high voltage side power source voltage of the secondary side voltage system and a low voltage side power source voltage of the primary side voltage system, a series circuit of a second resistor LSR2, LSR2a and second switching element HVN2 connected between the high voltage side power source voltage of the secondary side voltage system and the low voltage side power source voltage of the primary side voltage system, a latch malfunction protection circuit, operating on the secondary side voltage system, into which is input the voltage of a first connection point, which is a connection point of the first resistor LSR1, LSR1a and first switching element HVN1, and into which is input the voltage of a second connection point, which is a connection point of the second resistor LSR2, LSR2a and second switching element HVN2, a latch circuit, operating on the secondary side voltage system, into which is input the output of the latch malfunction protection circuit, a third switching element connected in parallel to the first resistor LSR1, LSR1a, a fourth switching element PM2a connected in parallel to the second resistor LSR2, LSR2a, and a logic gate circuit, operating on the secondary side voltage system, into which are input the voltages of the first and second connection points.

The level shift circuit 2, 2-1, 2-2 is configured so that a signal of the primary side voltage system that controls the turning on and off of the first switching element HVN1 is input into the first switching element HVN1, and a signal of the primary side voltage system that controls the turning on and off of the second switching element HVN2 is input into the second switching element HVN2, the latch malfunction protection circuit is configured so as to transmit a signal determined based on the voltages of the first and second connection points to the latch circuit when either one of the first and second switching elements HVN1, HVN2 is turned on, and so as not to transmit a signal determined based on the voltages of the first and second connection points to the latch circuit when the first and second switching elements HVN1, HVN2 are turned on simultaneously, and the logic gate circuit causes the third and fourth switching elements PM2a to be turned on when the voltages of the first and second connection points are both lower than the threshold value of the logic gate circuit.

The level shift circuit 2, 2-1, 2-2 can further include a feedback circuit that, in accordance with the output of the latch circuit, pulls the voltage of one of the first connection point and second connection point up to the high voltage side power source voltage of the secondary side voltage system, and pulls the voltage of the other down to the low voltage side power source voltage of the secondary side voltage system.

The feedback circuit includes, for example, a third resistor, one end of which is connected to the first connection point and to the other end of which is applied an inverted signal of the latch circuit output signal, and a fourth resistor, one end of which is connected to the second connection point and to the other end of which is applied a non-inverted signal of the latch circuit output signal.

The latch malfunction protection circuit, for example, is configured so as to raise the output impedance thereof to a high impedance when the voltages of the first and second connection points are both lower than the threshold value of the latch malfunction protection circuit.

The latch malfunction protection circuit, for example, is configured to include an inverting element 22a, a p-channel MOS transistor series circuit wherein first and second p-channel MOS transistors 22c are connected in series, and an n-channel MOS transistor series circuit wherein first and second n-channel MOS transistors 22d, 22e are connected in series.

In this case, the p-channel MOS transistor series circuit and n-channel MOS transistor series circuit are connected in series between the high voltage side power source voltage and low voltage side power source voltage of the secondary side voltage system, the first connection point is connected to the gates of the first p-channel MOS transistor 22c and first n-channel MOS transistor 22d, and the second connection point is connected to the input terminal of the inverting element 22a. Further, the output terminal of the inverting element 22a is connected to the gates of the second p-channel MOS transistor and second n-channel MOS transistor 22d, 22e, and a connection point of the p-channel MOS transistor series circuit and n-channel MOS transistor series circuit is connected to the data input terminal of the latch circuit.

The threshold value of the logic gate circuit is set to be equal to or lower than the threshold value of the latch malfunction protection circuit.

Also, the latch circuit, for example, is configured of a buffer circuit wherein a resistor is connected between the input side and the output side. In this case, the buffer circuit can be configured of two inverting elements 22a connected in series.

The level shift circuit 2, 2-1, 2-2 according to the invention can further include a third p-channel MOS transistor PM1 connected in parallel to the first resistor LSR1, LSR1a and a fourth p-channel MOS transistor PM2 connected in parallel to the second resistor LSR2, LSR2a. The gate of the third p-channel MOS transistor PM1 is connected to a connection point of the second resistor LSR2, LSR2a and fourth resistor, and the gate of the fourth p-channel MOS transistor PM2 is connected to a connection point of the first resistor LSR1, LSR1a and third resistor.

Further, the inverted signal of the latch circuit output signal has the low voltage side power source voltage of the secondary side voltage system, and the voltage division ratios of the first resistor LSR1, LSR1a and third resistor are fixed so that the voltage of the first connection point when the first switching element HVN1 and third switching element are in an off-state is between a voltage wherein the threshold value voltage of the fourth p-channel MOS transistor PM2 is subtracted from the high voltage side power source voltage of the secondary side voltage system and a voltage wherein the threshold value voltage of the latch malfunction protection circuit with respect to the first connection point voltage is added to the low voltage side power source voltage of the secondary side voltage system.

Also, the non-inverted signal of the latch circuit output signal has the low voltage side power source voltage of the secondary side voltage system, and the voltage division ratios of the first resistor LSR1, LSR1a and third resistor are fixed so that the voltage of the second connection point when the second switching element HVN2 and fourth switching element PM2a are in an off-state is between a voltage wherein the threshold value voltage of the third p-channel MOS transistor PM1 is subtracted from the high voltage side power source voltage of the secondary side voltage system and a voltage wherein the threshold value voltage of the latch malfunction protection circuit with respect to the second connection point voltage is added to the low voltage side power source voltage of the secondary side voltage system.

### Advantageous Effects of Invention

According to the invention, as it is possible to suppress a delay in dead time, or the like, in an operation of turning on a high side switching element configuring a circuit such as a half-bridge, it is possible to reduce power loss in a diode connected in parallel to the switching element.

### Brief Description of Drawings

[Fig. 1]

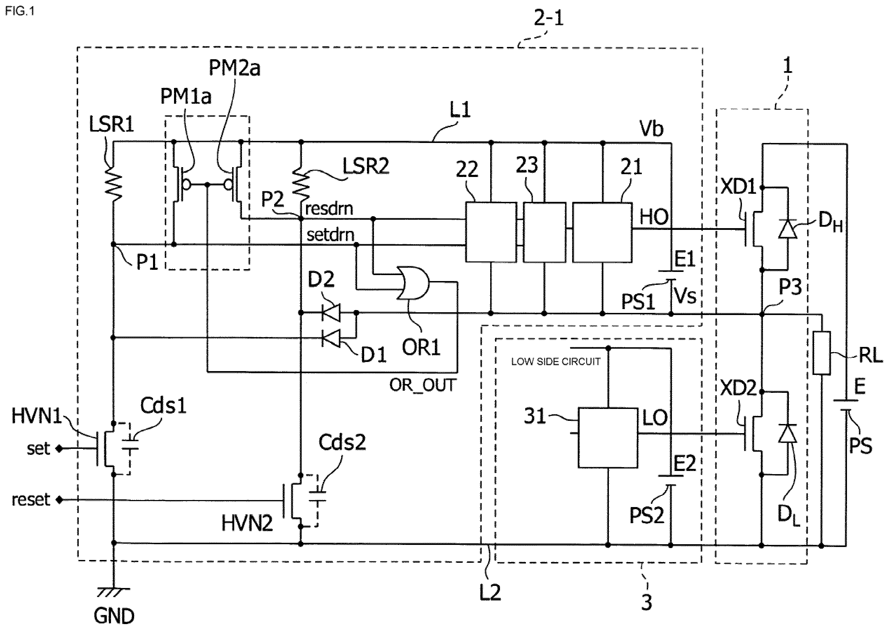

   Fig. 1 is a circuit diagram showing a half-bridge drive circuit in which is used a level shift circuit 2, 2-1, 2-2 according to one embodiment of the invention.
[Fig. 2]

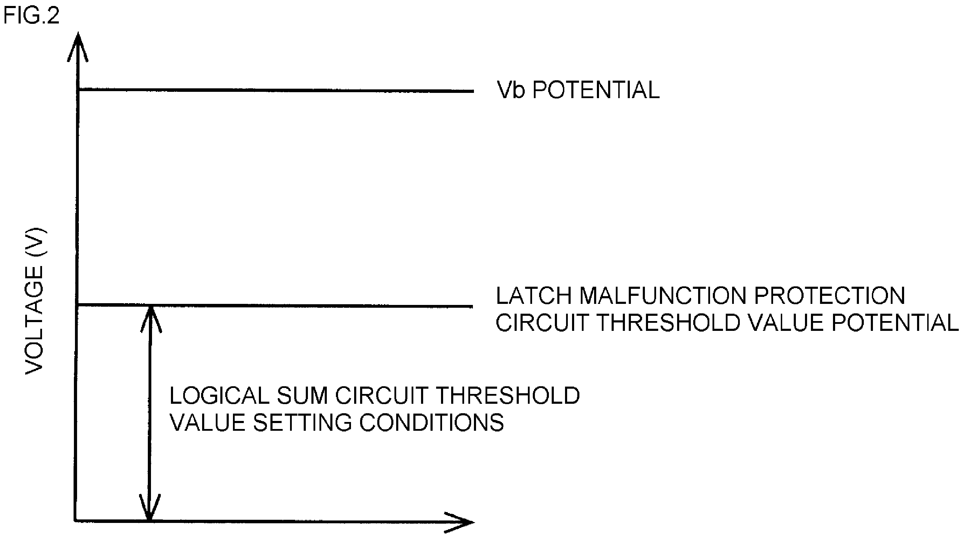

   Fig. 2 is a diagram illustrating threshold value setting conditions of a logical sum circuit.
[Fig. 3]

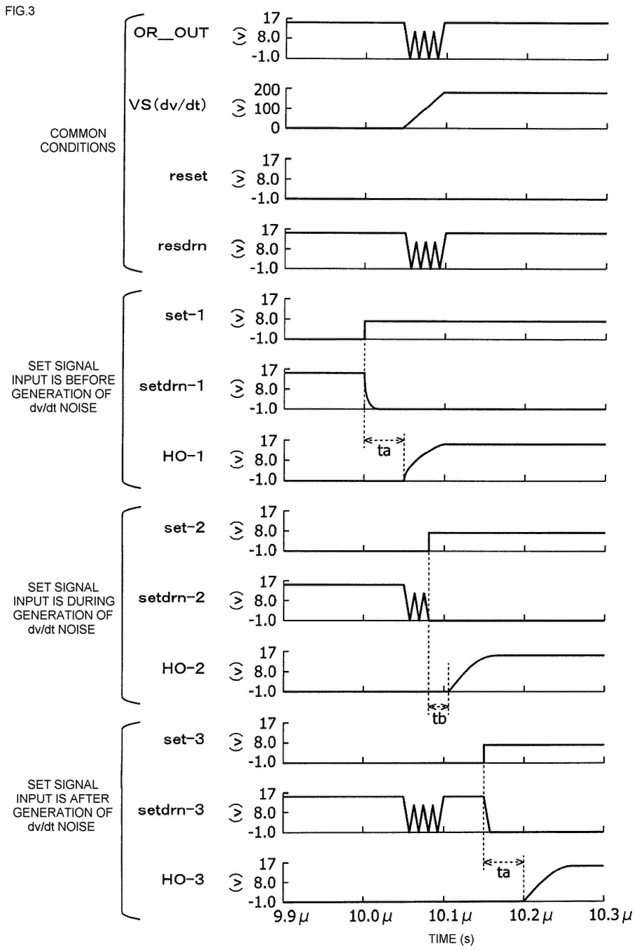

   Fig. 3 is a timing chart for illustrating an operation of the level shift circuit of Fig. 1.
[Fig. 4]

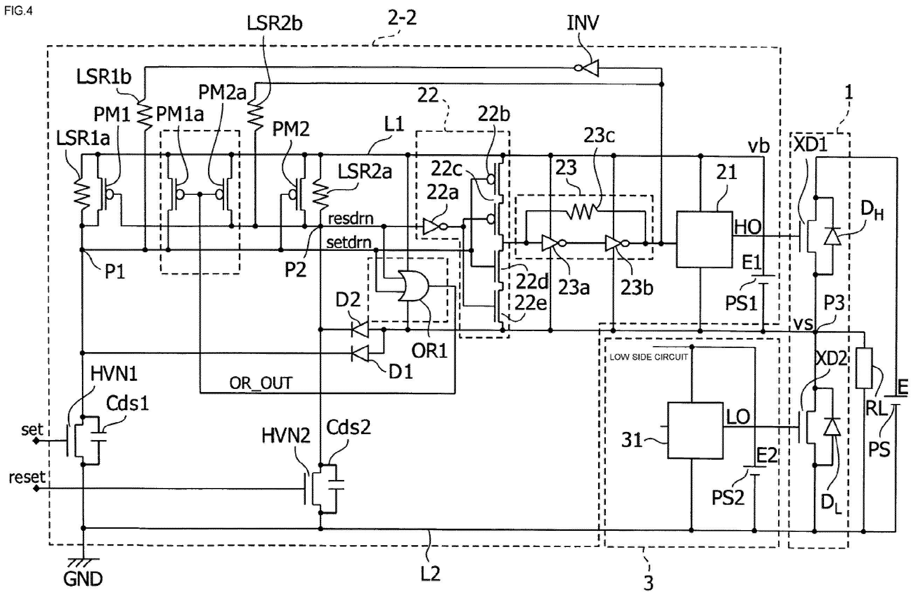

   Fig. 4 is a circuit diagram showing a half-bridge drive circuit in which is used a level shift circuit according to another embodiment of the invention.
[Fig. 5]
   Fig. 5 is a circuit diagram showing a half-bridge drive circuit in which is used a heretofore known level shift circuit.
[Fig. 6]
   Fig. 6 is a timing chart for illustrating a latch operation using set and reset signals in the level shift circuit.
[Fig. 7]
   Fig. 7 is a timing chart for illustrating dv/dt noise.
[Fig. 8]
   Fig. 8 is a circuit diagram showing a configuration example of a heretofore known latch malfunction protection circuit.
[Fig. 9]
   Fig. 9 is a timing chart for illustrating an operation of the heretofore known level shift circuit shown in Fig. 5.

### Description of Embodiments

Fig. 1 shows a circuit diagram of a half-bridge drive circuit in which is used a level shift circuit 2, 2-1, 2-2 according to one embodiment of the invention. In the half-bridge drive circuit, a level shift circuit 2, 2-1, 2-2 is provided in a high side drive unit 2-1. In Fig. 1, the same or corresponding reference signs are given to components the same as components of an example of a heretofore known half-bridge drive circuit shown in Fig. 5, and a detailed description thereof is omitted.

The level shift circuit 2, 2-1, 2-2 according to this embodiment has a configuration wherein p-channel MOS transistors PM1a and PM2a and a two-input logical sum circuit OR1, which is a logic gate circuit, are added to the components of the level shift circuit 2, 2-1, 2-2 of the heretofore known example shown in Fig. 5.

The p-channel MOS transistors PM1a and PM2a are connected in parallel to the resistors LSR1 and LSR2 respectively. The logical sum circuit OR1 is such that one input terminal is connected to the first connection point P1, the other input terminal to the second connection point P2, and the output terminal to the gate terminals of the p-channel MOS transistors PM1a and PM2a. As shown in Fig. 2, which illustrates threshold value setting conditions of the logical sum circuit OR1, the threshold value of the logical sum circuit OR1 is set to be equal to or lower than the threshold value of a latch malfunction protection circuit 22.

Hereafter, a description will be given of an operation of the level shift circuit 2, 2-1, 2-2 according to this embodiment, referring to Fig. 3, which is a timing chart corresponding to Fig. 9.

As shown in Fig. 3, as an n-channel MOS transistor HVN1 is turned on when the level of a set signal (set-1) changes to an "H" level, an "L" level level shift drain signal (setdrn-1) is output from the first connection point P1. In this case, as the latch malfunction protection function of the latch malfunction protection circuit 22 does not operate, a latch circuit 23 performs a latch operation, as a result of which an output signal HO-1 of a high side driver 21 rises, delayed by a unique delay time ta, in the circuits 22 and 23 and the high side driver 21, and a high side switching element XD1 is turned on.

On the switching element XD1 being turned on, the voltage of a level shift drain signal (resdrn) drops due to the dv/dt noise generated accompanying a rise in a voltage VS. Further, on the voltage of the level shift drain signal (resdrn) dropping to or below the threshold value of the logical sum circuit OR1, the level of an output signal OR_OUT of the logical sum circuit OR1 changes to an "L" level as the level of another level shift signal (setdrn-1) is already at an "L" level with respect to the logical sum circuit OR1. Because of this, the MOS transistors PM1a and PM2a are turned on, and the source-to-drain impedance of each of the MOS transistors PM1a and PM2a decreases. As this decrease in impedance works so as to cancel out drops in the voltages of the level shift drain signals (setdrn-1, resdrn), the voltages of the level shift drain signals (setdrn-1, resdrn) change so as to rise. Herein, Fig. 3 shows a case wherein the on-state resistance of each of n-channel MOS transistors HVN1 and HVN2 is set to be considerably lower than the on-state resistance of the MOS transistors PM1a and PM2a, and the level shift drain signal (setdrn-1) when the n-channel MOS transistor HVN1 is turned on by the set signal (set-1) does not oscillate, remaining at the "L" level.

On the voltages of the level shift drain signals (setdrn-1, resdrn) rising, and one thereof exceeding the threshold value of the logical sum circuit OR1, the level of the output signal OR_OUT of the logical sum circuit OR1 changes to an "H" level. As a result of this, the MOS transistors PM1a and PM2a, into the gates of which the "H" level output signal OR_OUT is input, are both turned off, and the source-to-drain impedance of each of the p-channel MOS transistors PM1a and PM2a increases, because of which the voltages of the level shift drain signals (setdrn-1, resdrn) change so as to drop. Because of this, the level of the output signal OR_OUT of the logical sum circuit OR1 changes to an "L" level, and the p-channel MOS transistors PM1a and PM2a are turned on again.

As these operations are carried out repeatedly while the dv/dt noise is being generated, the output signal of the logical sum circuit OR1 and the level shift drain signals (setdrn-1, resdrn) have oscillatory waveforms. However, as heretofore described, the oscillation of the level shift drain signal (setdrn-1) stops on the n-channel MOS transistor HVN1 being turned on.

Next, a description will be given of a case wherein the level of a set signal (set-2) changes to an "H" level while the voltage VS is rising because of the dead time, or the like, that is, a case wherein a period during which the voltage VS rises and a point at which the set signal (set-2) changes to an "H" level coincide. Herein, as the two level shift drain signals (setdrn-1, resdrn) are either both at an "L" level or both at an "H" level until the level of the set signal (set-2) changes to an "H" level, there is no change in the latch circuit 23. That is, when the level shift drain signals (setdrn-1, resdrn) are both at an "L" level, the input of a signal into the latch circuit 23 is blocked by the latch malfunction protection circuit 22. Meanwhile, as the input of the latch circuit 23 is of negative logic when the level shift drain signals (setdrn-1, resdrn) are both at an "H" level, the latch circuit 23 does not change.

In this case, the set signal (set-2) changes to an "H" level when the dv/dt noise accompanying the rise of the voltage VS is generated, that is, under a condition wherein the output signal of the logical sum circuit OR1 and level shift drain signals (setdrn-2, resdrn) exhibit oscillatory waveforms. As the n-channel MOS transistor HVN1 configuring a set side common source amplifier circuit is turned on when the set signal (set-2) changes to an "H" level, the level of the level shift drain signal (setdrn-2) changes to an "L" level. Because of this, the set signal (set-2) can be transmitted to the latch circuit 23 at a timing at which the set signal (set-2) changes to an "H" level owing to the oscillation in the level of the level shift drain signal (resdrn), even when a change caused by the dv/dt noise is occurring.

Thus, according to this embodiment, as is clear from a comparison of an output signal HO-2 shown in Fig. 3 and an output signal HO-2 shown in Fig. 9, it is possible to suppress the delay of the output signal HO-2 under the condition wherein the level of the set signal (set-2) changes to an "H" level while the voltage VS is rising. Consequently, it is possible to suppress the delay in the operation of turning on the switching element XD1, thereby reducing power loss in a diode D_{H} connected in parallel to the switching element XD1.

However, it is not the case that the set signal (set-2) can be transmitted to the latch circuit 23 at any timing once the output signal OR_OUT of the logical sum circuit OR1 starts to oscillate. That is, as the p-channel MOS transistors PM1a and PM2a are completely turned on when the logical sum circuit OR1 output signal value reaches a minimum value (when absolutely reaching an "L" level), the level shift drain signals (setdrn-2, resdrn) do not reach the "L" level despite the MOS transistors HVN1 and HVN2 being turned on, because of which, it is also conceivable that the set signal (set-2) is not transmitted to the latch circuit 23.

Also, oppositely to the above, the MOS transistors PM1a and PM2a are completely turned off when the logical sum circuit OR1 output signal OR_OUT value reaches a maximum value (when absolutely reaching an "H" level), but in this case, as the latch malfunction protection circuit 22 attains a condition such that it simply works so as to perform the original latch malfunction protection function, the set signal (set-2) is not transmitted to the latch circuit 23.

Consequently, in actuality, the set signal (set-2) is transmitted to the latch circuit 23 in a transition region (a region including neither the maximum value nor the minimum value) of the oscillatory waveform of the logical sum circuit OR1 output signal OR_OUT. However, depending on the on-state resistance value setting of each MOS transistor, the set signal (set-2) can be transmitted to the latch circuit 23 even when the value of the output signal OR_OUT is at the minimum.

When the level of a set signal (set-3) changes to an "H" level after the rise of the voltage VS due to dead time or the like is finished, the latch malfunction protection function of the latch malfunction protection circuit 22 does not operate. Because of this, an output signal HO-3 of the high side driver 21 rises, delayed by the unique delay time ta, in the circuits 22 and 23 and the high side driver 21, and at the same time, the switching element XD1 is turned on.

Also, although a description has been given thus far of a case in which the set signal changes to an "H" level, a reset signal (reset) is also transmitted to the latch circuit 23 in the same way when the level of the reset signal (reset) is changed to an "H" level.

Next, a description will be given of the level shift circuit 2, 2-1, 2-2 according to another embodiment of the invention with reference to Fig. 4, which is a circuit diagram showing a half-bridge drive circuit in which the level shift circuit 2, 2-1, 2-2 is used. The level shift circuit 2, 2-1, 2-2 according to the other embodiment is provided in a high side drive unit 2-2 configuring the half-bridge drive circuit.

The level shift circuit 2, 2-1, 2-2 according to this embodiment differs from the level shift circuit 2, 2-1, 2-2 shown in Fig. 1 in that p-channel MOS transistors PM1 and PM2, resistors LSR1b and LSR2b, and an inverter INV are added, and the latch malfunction protection circuit 22 and latch circuit 23 with the configurations shown in the drawing are used.

The p-channel MOS transistors PM1 and PM2 are connected in parallel to resistors LSR1a and LSR2a (corresponding to the resistors LSR1 and LSR2 shown in Fig. 1) respectively, and the gate terminals of the p-channel MOS transistors PM1 and PM2 are connected to the second and first connection points P2 and P1 respectively.

The resistor LSR1b is such that one end thereof is connected to the first connection point P1 while the other end is connected to the output terminal of the inverter INV. Also, the resistor LSR2b is such that one end thereof is connected to the second connection point P2 while the other end is connected to the output terminal of the latch circuit 23. The input terminal of the inverter INV is also connected to the output terminal of the latch circuit 23.

The resistors LSR1b and LSR2b, inverter INV, and p-channel MOS transistors PM1 and PM2 configure a feedback circuit.

The resistors LSR1a and LSR2a have the same resistance value, and the resistors LSR1b and LSR2b have the same resistance value.

The latch malfunction protection circuit 22 in this embodiment includes an inverter 22a and a series circuit of p-channel MOS transistors 22b and 22c and n-channel MOS transistors 22d and 22e. The inverter 22a is such that the input terminal thereof is connected to the connection point P2, while the output terminal is connected to the gate of the p-channel MOS transistor 22c and the gate of the n-channel MOS transistor 22e. The gate of the p-channel MOS transistor 22b and the gate of the n-channel MOS transistor 22d are connected to the connection point P1, and a connection point of the p-channel MOS transistor 22c and n-channel MOS transistor 22d is connected to the input terminal of the latch circuit 23. An output voltage E1 of a power source PS1 is applied as a power source voltage to the series circuit of the transistors 22b to 22e and to the inverter 22a.

Meanwhile, the latch circuit 23 in this embodiment, rather than being a set-reset type of flip-flop, is configured of inverters 23a and 23b connected in series and a resistor 23c connected between the input terminal of the inverter 23a (the input terminal of the latch circuit 23) and the output terminal of the inverter 23b (the output terminal of the latch circuit 23). The output voltage E1 of the power source PS1 is applied as a power source voltage to the inverters 23a and 23b.

The latch circuit 23 has a function of storing and outputting the value of the level of an input signal, that is, an output signal of the latch malfunction protection circuit 22, when the level is at an "L" level or "H" level, and, when the output signal of the latch malfunction protection circuit 22 reaches high impedance, holding and outputting the value stored immediately before high impedance is reached.

The latch malfunction protection circuit 22 operates so that the output of the circuit 22 reaches high impedance when dv/dt noise is generated and the voltages of level shift drain signals (setdrn, resdrn) both change to an "L" level. That is, as the n-channel MOS transistor 22d and p-channel MOS transistor 22c are both turned off when the voltages of the level shift drain signals (setdrn, resdrn) both change to an "L" level, the impedance at the output terminals thereof becomes high.

As the latch circuit 23 maintains the previous state when the impedance at the output terminal of the latch malfunction protection circuit 22 becomes high, it is possible to avoid the effect of the dv/dt noise.

As the p-channel MOS transistor 22b and n-channel MOS transistor 22e are turned off when the set signal (set) and reset signal (reset) are both at an "L" level, that is, when the voltage levels of the level shift drain signals (setdrn, resdrn) are both at an "H" level, the output impedance of the latch malfunction protection circuit 22 increases, as would be expected. As a result of this, the latch circuit 23 continues to maintain the previous state.

In this way, in this embodiment, the output impedance of the latch malfunction protection circuit 22 increases when the dv/dt noise is generated, and the effect of the dv/dt noise is thus eliminated.

The configuration of the latch malfunction protection circuit 22 is not limited to that shown in Fig. 4. That is, it is sufficient that the configuration is such that the output impedance thereof increases when the voltage level of each level shift drain signal (setdrn, resdrn) changes to an "L" level, and that when the voltage of one of the level shift drain signals (setdrn, resdrn) changes to an "L" level, a voltage of a commensurate level is output.

Next, a description will be given of the resistors LSR1b and LSR2b.

In Fig. 4, the resistors LSR1b and LSR2b are connected to the output side of the latch circuit 23 on the side opposite to the side of the first connection point P1 and second connection point P2 connected to the resistors LSR1a and LSR2a, the resistor LSR1b being connected via the inverter INV, and the resistor LSR2b being connected directly. Because of this, the levels of the terminals of the resistors LSR1b and LSR2b on this side are such that, for example, when the level of one is at an "H" level, the level of the other is at an "L" level, in accordance with the logic level of the output signal of the latch circuit 23. Therefore, of the first connection point P1 and second connection point P2, the one connection point connected to the resistor of which the level of the terminal on the side opposite to that of the connection point is at an "H" level is taken to be an H connection point, while the other connection point connected to the resistor of which the level of the terminal on the side opposite to that of the connection point is at an "L" level is taken to be an L connection point.

Herein, assuming that the terminal of the resistor LSR1b on the side opposite to that of the first connection point P1 is at an "H" level and the terminal of the resistor LSR2b on the side opposite to that of the second connection point P2 is at an "L" level, the gate of the p-channel MOS transistor PM1 changes to an "L" level, meaning that the p-channel MOS transistor PM1 is turned on, and functions as a pull-up resistor. As a result of this, the condition is such that the first connection point P1 is only pulled up by the resistors LSR1a and LSR1b and the p-channel MOS transistor PM1, and there is no pull-down factor. Also, the "H" level pulled up to is that of the voltage E1, which has the voltage VS as a reference. Consequently, the voltage level of the level shift drain signal (setdrn) output from the first connection point P1 is equivalent to the voltage E1, which has the voltage VS as a reference. Meanwhile, the value of the voltage of the level shift drain signal (resdrn) output from the second connection point P2 is the value of the voltage E1 divided in the resistors LSR2a and LSR2b (= E1 · RLSR2b/(RLSR2a + RLSR2b). Note that RLSR2a and RLSR2b are the resistance values of the resistors LSR2a and LSR2b respectively. At this time, the voltage division ratios of the resistors LSR2a and LSR2b are fixed in advance so that the level of the divided voltage value is an "H" level for the latch malfunction protection circuit 22, that is, so that it is higher than the threshold value voltage of the inverter 22a, which forms the threshold value voltage of the latch malfunction protection circuit 22 with respect to the voltage of the signal (resdrn).

In a case too in which the terminal of the resistor LSR1b on the side opposite to that of the first connection point P1 is at an "L" level and the terminal of the resistor LSR2b on the side opposite to that of the second connection point P2 is at an "H" level, the voltage division ratios of the resistors LSR1a and LSR1b are fixed in advance so that the level of the voltage E1 divided in the resistors LSR1a and LSR1b is an "H" level for the latch malfunction protection circuit 22. That is, the voltage division ratios are fixed so that the voltage of the level shift drain signal (setdrn) output from the first connection point P1, that is, the value of the voltage E1 divided in the resistors LSR1a and LSR1b (= E1 · RLSR1b/(RLSR1a + RLSR1b), noting that RLSRla and RLSRlb are the resistance values of the resistors LSR1a and LSR1b respectively, is higher than the threshold value voltage of the inverter configured of the MOS transistors 22b and 22d of the latch malfunction protection circuit 22, that is, higher than the threshold value voltage of the latch malfunction protection circuit 22 with respect to the voltage of the signal (setdrn).

By fixing the voltage division ratios of the resistors LSR1a and LSR1b and the voltage division ratios of the resistors LSR2a and LSR2b in this way, it is guaranteed that "when an "L" level input signal is input into only one terminal of the signals (set, reset) input into the high side drive unit 2-2, the latch malfunction protection circuit 22 does not block the input signal".

Next, a description will be given of the feedback circuit formed of the resistors LSR1b and LSR2b, the inverter INV, and the p-channel MOS transistors PM1 and PM2.

When assuming that the resistance values of the resistors LSR1a and LSR2a are the same and that the resistance values of the resistors LSR1b and LSR2b are the same, and temporarily ignoring the on-state resistance of the p-channel MOS transistors PM1 and PM2, the gate-to-source voltage of the p-channel MOS transistor whose gate is connected to the H connection point (the "H" level connection point of the first and second connection points P1 and P2) is zero. Also, the gate-to-source voltage of the p-channel MOS transistor whose gate is connected to the L connection point (the "L" level connection point of the connection points P1 and P2) is E1 · Ra/(Ra + Rb). Ra is the resistance value of either one of the resistors LSR1a and LSR2a, while Rb is the resistance value of either one of the resistors LSR1b and LSR2b.

The value of the gate-to-source voltage E1 · Ra/ (Ra + Rb) is set at a value slightly higher than the threshold value voltage of the p-channel MOS transistors PM1 and PM2. Because of this, the MOS transistor whose gate is connected to the L connection point has a limited on-state resistance Ron, and the MOS transistor having the on-state resistance Ron has a configuration such that it is connected in parallel to the resistor LSR1a or LSR2a. For example, taking E1 to be E1 = 15V, the threshold value voltage of each of the p-channel MOS transistors PM1 and PM2 to be 2.5V (this voltage, taking VS as a reference, is 12.5V = 15V - 2.5V), RLSRla = RLSR2a = Ra = 10kΩ, and RLSRlb = RLSR2b = Rb = 45kΩ, the gate-to-source voltage is E1 · Ra/(Ra + Rb) = 2.7V, which is 0.2V higher than the threshold value voltage (this voltage, taking VS as a reference, is 12.3V = 15V - 2.7V).

In this way, in this embodiment, as the value of the gate-to-source voltage E1 · Ra/(Ra + Rb) of the p-channel MOS transistor whose gate is connected to the L connection point (one of the p-channel MOS transistors PM1 and PM2, whose drain terminal is connected to the H connection point) is set to be a value near the threshold value voltage of the p-channel MOS transistors PM1 and PM2, the value of the on-state resistance Ron is a limited value other than zero.

Consequently, even when the n-channel MOS transistor HVN1 or HVN2 connected to the H connection point is turned on, shoot-through current is prevented from flowing between a place in a voltage Vb and a place in a ground voltage.

Of the parallel connection of the p-channel MOS transistor PM1 and resistor LSR1a and the parallel connection of the p-channel MOS transistor PM2 and resistor LSR2a, the parallel connection having the p-channel MOS transistor whose gate is connected to the L connection point (the "L" level connection point of the connection points P1 and P2) and that has the on-state resistance Ron is connected between the H connection point (the "H" level connection point of the connection points P1 and P2) and a power source line L1 to which the potential Vb is applied, meaning that the combined resistance value between the H connection point and line L1 is smaller than the combined resistance value between the H connection point and power source line L1 in the embodiment shown in Fig. 1. Meanwhile, the on-state resistance Ron has no connection with the L connection point.

As parasitic capacitors Cds1 and Cds2 exist between the source and drain of the n-channel MOS Transistors HVN1 and HVN2, as previously described, the on-state resistance Ron causes a discrepancy between a time constant with respect to the H connection point and a time constant with respect to the L connection point, causing the former time constant to be smaller than the latter time constant.

As a result of this, when the voltages of the H connection point and L connection point change due to the dv/dt noise, the voltage of the H connection point changes more quickly than the voltage of the L connection point. Consequently, when the voltages of both the H connection point and L connection point rise, a large difference occurs between the time taken for the voltage of the H connection point to reach the threshold value voltage of the inverter of the latch malfunction protection circuit 22 (the threshold value voltage of the inverter configured of the inverter 22a and MOS transistors 22b and 22d) and the time taken for the voltage of the L connection point to reach the same threshold value voltage. The latch circuit 23 is set or reset so as to eventually maintain the original value in accordance with this time difference. Therefore, according to this embodiment, it is possible to more reliably prevent malfunction due to the dv/dt noise.

As heretofore described, the feedback circuit formed of the resistors LSR1b and LSR2b, the inverter INV, and the p-channel MOS transistors PM1 and PM2 pulls the voltage of one of the first connection point P1 and second connection point P2 up to the high voltage side power source voltage of a secondary side voltage system, and pulls the other voltage down to the low voltage side power source voltage of the secondary side voltage system, in accordance with the output signal of the latch circuit 23, because of which, malfunction due to the dv/dt noise is more reliably prevented.

With the level shift circuit 2, 2-1, 2-2 of this embodiment too, in the same way as with the level shift circuit 2, 2-1, 2-2 shown in Fig. 1, an advantage is obtained in that the delay in the operation of turning on the switching element XD1 is suppressed, thereby reducing power loss in the diode D_{H}.

Heretofore, it has been assumed that the threshold value voltage of the inverter 22a and the threshold value voltage of the inverter configured of the MOS transistors 22b and 22d are the same but, this being in order to simplify the description, it is not necessary that the threshold value voltages are the same.

Also, in this embodiment too, a circuit with the configuration shown in Fig. 8 is used as the latch malfunction protection circuit 22, but is also possible to use a set-reset type of flip-flop as the latch circuit 23 combined with the latch malfunction protection circuit 22.

Also, it being sufficient that the logical sum circuit OR1 is a circuit (logic gate circuit) that realizes the heretofore described operation, it is not limited to a simple logical sum circuit (OR gate circuit).

### Reference Signs List

- 1: Output circuit
- 2, 2-1, 2-2: High side drive unit
- 3: Low side drive unit
- 21: High side driver
- 22: Latch malfunction protection circuit
- 22a: Inverter
- 22b, 22c: p-channel MOS transistor
- 22d, 22e: n-channel MOS transistor
- 23: Latch circuit
- 23a, 23b: Inverter
- 23c: Resistor
- 31: Low side driver
- Cds1. Cds2: Parasitic capacitor
- D1, D2, D_{H}, D_{L}: Diode
- PS1, PS2: Power source
- PM1, PM2, PM1a, PM2a: p-channel MOS transistor
- LSR1, LSR2, LSR1a, LSR2a, LSR1b, LSR2b: Resistor
- HVN1, HVN2: n-channel MOS transistor
- INV: Inverter
- OR1: Logic gate circuit (logical sum circuit)
- RL: Load
- XD1, XD2: Switching element

## Claims

1. A level shift circuit that transmits an input signal from a primary side voltage system (3) to a system operating on a secondary side voltage system (2, 2-1, 2-2) differing from the primary side voltage system (3), the level shift circuit (2, 2-1, 2-2) being **characterized by** comprising:
a series circuit of a first resistor (LSR1, LSR1a) and first switching element (HVN1) connected between a high voltage side power source (PS1) voltage of the secondary side voltage system (2, 2-1, 2-2) and a low voltage side power source (PS2) voltage of the primary side voltage system (3);
a series circuit of a second resistor (LSR2, LSR2a) and second switching element (HVN2) connected between the high voltage side power source (PS1) voltage of the secondary side voltage system (2, 2-1, 2-2) and the low voltage side power source (PS2) voltage of the primary side voltage system (3);
a latch malfunction protection circuit (22), operating on the secondary side voltage system (2, 2-1, 2-2), into which is input the voltage of a first connection point (P1), which is a connection point of the first resistor (LSR1, LSR1a) and first switching element (HVN1), and into which is input the voltage of a second connection point (P2), which is a connection point of the second resistor (LSR2, LSR2a) and second switching element (HVN2);
a latch circuit (23), operating on the secondary side voltage system (2, 2-1, 2-2), into which is input the output of the latch malfunction protection circuit (22);
a third switching element (PM1a) connected in parallel to the first resistor (LSR1, LSR1a);
a fourth switching element (PM2a) connected in parallel to the second resistor (LSR2, LSR2a); and
a logic gate circuit (OR1), operating on the secondary side voltage system (2, 2-1, 2-2), into which are input the voltages of the first and second connection points (P1, P2), wherein
a signal of the primary side voltage system (3) that controls the turning on and off of the first switching element (HVN1) is input into the first switching element (HVN1), and a signal of the primary side voltage system (3) that controls the turning on and off of the second switching element (HVN2) is input into the second switching element (HVN2),
the latch malfunction protection circuit (22) is configured so as to transmit a signal determined based on the voltages of the first and second connection points (P1, P2) to the latch circuit (23) when either one of the first and second switching elements (HVN1, HVN2) is turned on, and so as not to transmit a signal determined based on the voltages of the first and second connection points (P1, P2) to the latch circuit (23) when the first and second switching elements (HVN1, HVN2) are turned on simultaneously, and
the logic gate circuit (OR1) causes the third and fourth switching elements (PM1a, PM2a) to be turned on when the voltages of the first and second connection points (P1, P2) are both lower than the threshold value of the logic gate circuit (OR1).

2. The level shift circuit according to claim 1, **characterized by** further comprising:
a feedback circuit that, in accordance with the output of the latch circuit (23), pulls the voltage of one of the first and second connection points (P1, P2) up to the high voltage side power source voltage of the secondary side voltage system (2, 2-1, 2-2), and pulls the voltage of the other down to the low voltage side power source voltage of the secondary side voltage system (2, 2-1, 2-2).

3. The level shift circuit according to claim 2, **characterized in that**
the feedback circuit includes a third resistor (LSR1b), one end of which is connected to the first connection point (P1) and to the other end of which is applied an inverted signal of the latch circuit (23) output signal, and a fourth resistor (LSR2b), one end of which is connected to the second connection point (P2) and to the other end of which is applied a non-inverted signal of the latch circuit (23) output signal.

4. The level shift circuit according to claim 1, **characterized in that**
the latch malfunction protection circuit (22) is configured so as to raise the output impedance thereof to a high impedance when the voltages of the first and second connection points (P1, P2) are both lower than the threshold value of the latch malfunction protection circuit (22).

5. The level shift circuit according to claim 1, **characterized in that**
the latch malfunction protection circuit (22) includes an inverting element (22a), a p-channel MOS transistor series circuit wherein first and second p-channel MOS transistors (PM1, PM2) are connected in series, and an n-channel MOS transistor series circuit wherein first and second n-channel MOS transistors (22d, 22e) are connected in series, wherein
the p-channel MOS transistor series circuit and n-channel MOS transistor series circuit are connected in series between the high voltage side power source voltage and low voltage side power source voltage of the secondary side voltage system (2, 2-1, 2-2),
the first connection point (P1) is connected to the gates of the first p-channel MOS transistor (22c) and first n-channel MOS transistor (22d),
the second connection point (P2) is connected to the input terminal of the inverting element (22a),
the output terminal of the inverting element (22a) is connected to the gates of the second p-channel MOS transistor (22c) and second n-channel MOS transistor (22e), and
a connection point of the p-channel MOS transistor series circuit and n-channel MOS transistor series circuit is connected to the data input terminal of the latch circuit (23) .

6. The level shift circuit according to claim 5, **characterized in that** the threshold value of the logic gate circuit (OR1) is set to be equal to or lower than the threshold value of the latch malfunction protection circuit (22).

7. The level shift circuit according to claim 4, **characterized in that** the latch circuit (23) is formed of a buffer circuit wherein a resistor (23c) is connected between the input side and the output side.

8. The level shift circuit according to claim 7, **characterized in that** the buffer circuit is formed of two inverting elements (23a, 23b) connected in series.

9. The level shift circuit according to claim 3, **characterized by** further comprising:
a third p-channel MOS transistor (PM1) connected in parallel to the first resistor (LSR1a) and a fourth p-channel MOS transistor (PM2) connected in parallel to the second resistor (LSR2a), wherein
the gate of the third p-channel MOS transistor is connected to a connection point of the second resistor (LSR2a) and fourth resistor (LSR2b), and the gate of the fourth p-channel MOS transistor is connected to a connection point of the first resistor (LSR1a) and third resistor (LSR1b).

10. The level shift circuit according to claim 9, **characterized in that**
the inverted signal of the latch circuit (23) output signal has the low voltage side power source voltage of the secondary side voltage system (2, 2-1, 2-2), and the voltage division ratios of the first resistor (LSR1a) and third resistor (LSR1b) are fixed so that the voltage of the first connection point (P1) when the first switching element (HVN1) and third switching element (PM1a) are in an off-state is between a voltage wherein the threshold value voltage of the fourth p-channel MOS (PM2) transistor is subtracted from the high voltage side power source voltage of the secondary side voltage system (2, 2-1, 2-2) and a voltage wherein the threshold value voltage of the latch malfunction protection circuit (22) with respect to the first connection point (P1) voltage is added to the low voltage side power source voltage of the secondary side voltage system (2, 2-1, 2-2), and
the non-inverted signal of the latch circuit (23) output signal has the low voltage side power source voltage of the secondary side voltage system (2, 2-1, 2-2), and the voltage division ratios of the second resistor (LSR2a) and fourth resistor (LSR2b) are fixed so that the voltage of the second connection point (P2) when the second switching element (HVN2) and fourth switching element (PM2a) are in an off-state is between a voltage wherein the threshold value voltage of the third p-channel MOS transistor (PM1) is subtracted from the high voltage side power source voltage of the secondary side voltage system (2, 2-1, 2-2) and a voltage wherein the threshold value voltage of the latch malfunction protection circuit (22) with respect to the second connection point (P2) voltage is added to the low voltage side power source voltage of the secondary side voltage system (2, 2-1, 2-2).

## Patentansprüche

1. Pegelverschiebungsschaltung, die ein Eingangssignal von einem Primärseitenspannungssystem (3) an ein System sendet, das bei einem Sekundärseitenspannungssystem (2, 2-1, 2-2) arbeitet, das sich von dem Primärseitenspannungssystem (3) unterscheidet, wobei die Pegelverschiebungsschaltung (2, 2-1, 2-2) **dadurch gekennzeichnet ist, dass** sie umfasst:
eine Reihenschaltung eines ersten Widerstandes (LSR1, LSR1a) und eines ersten Schaltelements (HVN1), die zwischen einer Hochspannungsseitenstromquellen- (PS1) -Spannung des Sekundärseitenspannungssystems (2, 2-1, 2-2) und einer Niederspannungsseitenstromquellen-(PS2) -Spannung des Primärseitenspannungssystems (3) verbunden ist;
eine Reihenschaltung eines zweiten Widerstandes (LSR2, LSR2a) und eines zweiten Schaltelements (HVN2), die zwischen der Hochspannungsseitenstromquellen- (PS1) - Spannung des Sekundärseitenspannungssystems (2, 2-1, 2-2) und der Niederspannungsseitenstromquellen- (PS2) -Spannung des Primärseitenspannungssystems (3) verbunden ist;
eine Verriegelungsfehlfunktionsschutzschaltung (22), die bei dem Sekundärseitenspannungssystem (2, 2-1, 2-2) arbeitet, in welche die Spannung eines ersten Verbindungspunktes (P1) eingegeben wird, der ein Verbindungspunkt des ersten Widerstandes (LSR1, LSR1a) und des ersten Schaltelements (HVN1) ist, und in welche die Spannung eines zweiten Verbindungspunktes (P2) eingegeben wird, der ein Verbindungspunkt des zweiten Widerstandes (LSR2, LSR2a) und des zweiten Schaltelements (HVN2) ist;
eine Verriegelungsschaltung (23), die bei dem Sekundärseitenspannungssystem (2, 2-1, 2-2) arbeitet, in welche die Ausgabe der Verriegelungsfehlfunktionsschutzschaltung (22) eingegeben wird;
ein drittes Schaltelement (PM1a), das mit dem ersten Widerstand (LSR1, LSR1a) parallel verbunden ist;
ein viertes Schaltelement (PM2a), das mit dem zweiten Widerstand (LSR2, LSR2a) parallel verbunden ist; und
eine Logikgatterschaltung (OR1), die bei dem Sekundärseitenspannungssystem (2, 2-1, 2-2) arbeitet, in welche die Spannungen der ersten und zweiten Verbindungspunkte (P1, P2) eingegeben werden, wobei ein Signal des Primärseitenspannungssystems (3), welches das Ein- und Ausschalten des ersten Schaltelements (HVN1) steuert, in das erste Schaltelement (HVN1) eingegeben wird, und ein Signal des Primärseitenspannungssystems (3), welches das Ein- und Ausschalten des zweiten Schaltelements (HVN2) steuert, in das zweite Schaltelement (HVN2) eingegeben wird,
die Verriegelungsfehlfunktionsschutzschaltung (22) derart konfiguriert ist, dass sie ein Signal, das basierend auf den Spannungen der ersten und zweiten Verbindungspunkte (P1, P2) bestimmt wird, an die Verriegelungsschaltung (23) sendet, wenn eines der ersten und zweiten Schaltelemente (HVN1, HVN2) eingeschaltet wird, und dass sie kein Signal, das basierend auf den Spannungen der ersten und zweiten Verbindungspunkte (P1, P2) bestimmt wird, an die Verriegelungsschaltung (23) sendet, wenn die ersten und zweiten Schaltelemente (HVN1, HVN2) gleichzeitig eingeschaltet werden, und
die Logikgatterschaltung (OR1) bewirkt, dass die dritten und vierten Schaltelemente (PM1a, PM2a) eingeschaltet werden, wenn die Spannungen der ersten und zweiten Verbindungspunkte (P1, P2) beide niedriger als der Schwellenwert der Logikgatterschaltung (OR1) sind.

2. Pegelverschiebungsschaltung nach Anspruch 1, **dadurch gekennzeichnet, dass** sie ferner umfasst:
eine Rückkopplungsschaltung, die, gemäß der Ausgabe der Verriegelungsschaltung (23) die Spannung von einem der ersten und zweiten Verbindungspunkte (P1, P2) auf die Hochspannungsseitenstromquellenspannung des Sekundärseitenspannungssystems (2, 2-1, 2-2) hochzieht und die Spannung der anderen nach unten auf die Niederspannungsseitenstromquellenspannung des Sekundärseitenspannungssystems (2, 2-1, 2-2) zieht.

3. Pegelverschiebungsschaltung nach Anspruch 2, **dadurch gekennzeichnet, dass**
die Rückkopplungsschaltung einen dritten Widerstand (LSR1b) umfasst, dessen eines Ende mit dem ersten Verbindungspunkt (P1) verbunden ist, und an dessen anderen Ende ein invertiertes Signal des Verriegelungsschaltungs- (23) -Ausgangssignals angelegt ist, und einen vierten Widerstand (LSR2b), dessen eines Ende mit dem zweiten Verbindungspunkt (P2) verbunden ist und an dessen anderen Ende ein nichtinvertiertes Signal des Verriegelungsschaltungs-(23) -Ausgangssignals angelegt ist.

4. Pegelverschiebungsschaltung nach Anspruch 1, **dadurch gekennzeichnet, dass** die Verriegelungsfehlfunktionsschutzschaltung (22) konfiguriert ist, dass sie die Ausgangsimpedanz davon auf eine hohe Impedanz anhebt, wenn die Spannungen der ersten und zweiten Verbindungspunkte (P1, P2) beide niedriger sind als der Schwellenwert der Verriegelungsfehlfunktionsschutzschaltung (22).

5. Pegelverschiebungsschaltung nach Anspruch 1, **dadurch gekennzeichnet, dass**
die Verriegelungsfehlfunktionsschutzschaltung (22) ein invertierendes Element (22a), eine p-Kanal-MOS-Transistorserienschaltung, wobei erste und zweite p-Kanal-MOS-Transistoren (PM1, PM2) in Reihe verbunden sind, und eine n-Kanal-MOS-Transistorserienschaltung, wobei erste und zweite n-Kanal-MOS-Transistoren (22d, 22e) in Reihe verbunden sind, umfasst, wobei die p-Kanal-MOS-Transistorserienschaltung und n-Kanal-MOS-Transistorserienschaltung zwischen der Hochspannungsseitenstromquellenspannung und der Niederspannungsseitenstromquellenspannung des Sekundärseitenspannungssystems (2, 2-1, 2-2) in Reihe verbunden sind,
der erste Verbindungspunkt (P1) mit den Gates des ersten p-Kanal-MOS-Transistors (22c) und des ersten n-Kanal-MOS-Transistors (22d) verbunden ist,
der zweite Verbindungspunkt (P2) mit dem Eingangsanschluss des invertierenden Elements (22a) verbunden ist,
der Ausgangsanschluss des invertierenden Elements (22a) mit den Gates des zweiten p-Kanal-MOS-Transistors (22c) und des zweiten n-Kanal-MOS-Transistors (22e) verbunden ist, und
ein Verbindungspunkt der p-Kanal-MOS-Transistorserienschaltung und der n-Kanal-MOS-Transistorserienschaltung mit dem Dateneingangsanschluss der Verriegelungsschaltung (23) verbunden ist.

6. Pegelverschiebungsschaltung nach Anspruch 5, **dadurch gekennzeichnet, dass** der Schwellenwert der Logikgatterschaltung (OR1) derart eingestellt ist, dass er gleich oder niedriger als der Schwellenwert der Verriegelungsfehlfunktionsschutzschaltung (22) ist.

7. Pegelverschiebungsschaltung nach Anspruch 4, **dadurch gekennzeichnet, dass** die Verriegelungsschaltung (23) aus einer Pufferschaltung gebildet ist, in der ein Widerstand (23c) zwischen der Eingangsseite und der Ausgangsseite verbunden ist.

8. Pegelverschiebungsschaltung nach Anspruch 7, **dadurch gekennzeichnet, dass** die Pufferschaltung aus zwei invertierenden Elementen (23a, 23b) gebildet ist, die in Reihe verbunden sind.

9. Pegelverschiebungsschaltung nach Anspruch 3, **dadurch gekennzeichnet, dass** sie ferner umfasst:
einen dritten p-Kanal-MOS-Transistor (PM1), der mit dem ersten Widerstand (LSR1a) parallel verbunden ist, und einen vierten p-Kanal-MOS-Transistor (PM2), der mit dem zweiten Widerstand (LSR2a) parallel verbunden ist, wobei
das Gate des dritten p-Kanal-MOS-Transistors mit einem Verbindungspunkt des zweiten Widerstands (LSR2a) und des vierten Widerstands (LSR2b) verbunden ist, und das Gate des vierten p-Kanal-MOS-Transistors mit einem Verbindungspunkt des ersten Widerstands (LSR1a) und des dritten Widerstands (LSR1b) verbunden ist.

10. Pegelverschiebungsschaltung nach Anspruch 9, **dadurch gekennzeichnet, dass**
das invertierte Signal des Verriegelungsschaltungs-(23) -Ausgangssignals die Niederspannungsseitenstromquellenspannung des Sekundärseitenspannungssystems (2, 2-1, 2-2) aufweist und die Spannungsteilungsverhältnisse des ersten Widerstandes (LSR1a) und des dritten Widerstandes (LSR1b) feststehend sind, sodass die Spannung des ersten Verbindungspunktes (P1), wenn sich das erste Schaltelement (HVN1) und das dritte Schaltelement (PM1a) in einem Aus-Zustand befinden, zwischen einer Spannung liegt, bei der die Schwellenwertspannung des vierten p-Kanal-MOS-Transistors (PM2) von der Hochspannungsseitenstromquellenspannung des Sekundärseitenspannungssystems (2, 2-1, 2-2) subtrahiert ist, und einer Spannung, bei der die Schwellenwertspannung der Verriegelungsfehlfunktionsschutzschaltung (22) in Bezug auf die erste Verbindungspunkt- (P1) -Spannung zu der Niederspannungsseitenstromquellenspannung des Sekundärseitenspannungssystems (2, 2-1, 2-2) addiert ist, und
das nichtinvertierte Signal des Verriegelungsschaltungs- (23) -Ausgangssignals die Niederspannungsseitenstromquellenspannung des Sekundärseitenspannungssystems (2, 2-1, 2-2) aufweist und die Spannungsteilungsverhältnisse des zweiten Widerstandes (LSR2a) und des vierten Widerstandes (LSR2b) feststehend sind, sodass die Spannung des zweiten Verbindungspunktes (P2), wenn sich das zweite Schaltelement (HVN2) und das vierte Schaltelement (PM2a) in einem Aus-Zustand befinden, zwischen einer Spannung liegt, bei der die Schwellenwertspannung des dritten p-Kanal-MOS-Transistors (PM1) von der Hochspannungsseitenstromquellenspannung des Sekundärseitenspannungssystems (2, 2-1, 2-2) subtrahiert ist, und einer Spannung, bei der die Schwellenwertspannung der Verriegelungsfehlfunktionsschutzschaltung (22) in Bezug auf die zweite Verbindungspunkt- (P2) -Spannung zu der Niederspannungsseitenstromquellenspannung des Sekundärseitenspannungssystems (2, 2-1, 2-2) addiert ist.

## Revendications

1. Circuit de décalage de niveau qui transmet un signal d'entrée d'un système de tension côté primaire (3) à un système opérant sur un système de tension côté secondaire (2, 2-1, 2-2) différant du système de tension côté primaire (3), le circuit de décalage de niveau (2, 2-1, 2-2) étant **caractérisé en ce qu'**il comprend :
un circuit série d'une première résistance (LSR1, LSR1a) et d'un premier élément de commutation (HVN1) connecté entre une tension de source d'alimentation côté haute tension (PS1) du système de tension côté secondaire (2, 2-1, 2-2) et une tension de source d'alimentation côté basse tension (PS2) du système de tension côté primaire (3) ;
un circuit série d'une deuxième résistance (LSR2, LSR2a) et d'un deuxième élément de commutation (HVN2) connecté entre la tension de source d'alimentation côté haute tension (PS1) du système de tension côté secondaire (2, 2-1, 2-2) et la tension de source d'alimentation côté basse tension (PS2) du système de tension côté primaire (3) ;
un circuit de protection contre le disfonctionnement de verrouillage (22), opérant sur le système de tension côté secondaire (2, 2-1, 2-2), dans lequel on fait entrer la tension d'un premier point de connexion (P1) qui est un point de connexion de la première résistance (LSR1, LSR1a) et du premier élément de commutation (HVN1), et dans lequel on fait entrer la tension d'un deuxième point de connexion (P2) qui est un point de connexion de la deuxième résistance (LSR2, LSR2a) et d'un deuxième élément de commutation (HVN2) ;
un circuit de verrouillage (23), opérant sur le système de tension côté secondaire (2, 2-1, 2-2), dans lequel on fait entrer la sortie du circuit de protection contre le disfonctionnement de verrouillage (22) ;
un troisième élément de commutation (PM1a) connecté en parallèle à la première résistance (LSR1, LSR1a) ;
un quatrième élément de commutation (PM2a) connecté en parallèle à la deuxième résistance (LSR2, LSR2a) ; et
un circuit de porte logique (OR1), opérant sur le système de tension côté secondaire (2, 2-1, 2-2), dans lequel on fait entrer les tensions des premier et deuxième points de connexion (P1, P2), dans lequel
un signal du système de tension côté primaire (3) qui contrôle la mise en circuit et hors circuit du premier élément de commutation (HVN1) est introduit dans le premier élément de commutation (HVN1), et un signal du système de tension côté primaire (3) qui contrôle la mise en circuit et hors circuit du deuxième élément de commutation (HVN2) est introduit dans le deuxième élément de commutation (HVN2),
le circuit de protection contre le disfonctionnement de verrouillage (22) est configuré de manière à transmettre un signal, déterminé sur la base des tensions des premier et deuxième points de connexion (P1, P2), au circuit de verrouillage (23) lorsque l'un ou l'autre des premier et deuxième éléments de commutation (HVN1, HVN2) est mis en circuit, et de manière à ne pas transmettre un signal déterminé sur la base des tensions des premier et deuxième points de connexion (P1, P2) au circuit de verrouillage (23) lorsque les premier et deuxième éléments de commutation (HVN1, HVN2) sont mis en circuit simultanément, et
le circuit de porte logique (OR1) fait en sorte que les troisième et quatrième éléments de commutation (PM1a, PM2a) soient mis en circuit lorsque les tensions des premier et deuxième points de connexion (P1, P2) sont toutes deux inférieures à la valeur de seuil du circuit de porte logique (OR1).

2. Circuit de décalage de niveau selon la revendication 1, **caractérisé en ce qu'**il comprend en outre :
un circuit de rétroaction lequel, en fonction de la sortie du circuit de verrouillage (23), tire la tension de l'un des premier et deuxième points de connexion (P1, P2) vers le haut vers la tension de source d'alimentation côté haute tension du système de tension côté secondaire (2, 2-1, 2-2), et tire la tension de l'autre vers le bas vers la tension de source d'alimentation côté basse tension du système de tension côté secondaire (2, 2-1, 2-2).

3. Circuit de décalage de niveau selon la revendication 2, **caractérisé en ce que**
le circuit de rétroaction comprend une troisième résistance (LSR1b), dont une extrémité est connectée au premier point de connexion (P1) et à l'autre extrémité de laquelle on applique un signal inversé du signal de sortie de circuit de verrouillage (23), et une quatrième résistance (LSR2b), dont une extrémité est connectée au deuxième point de connexion (P2) et à l'autre extrémité de laquelle on applique un signal non inversé du signal de sortie de circuit de verrouillage (23).

4. Circuit de décalage de niveau selon la revendication 1, **caractérisé en ce que**
le circuit de protection contre le disfonctionnement de verrouillage (22) est configuré de manière à élever l'impédance de sortie de celui-ci à une haute impédance lorsque les tensions des premier et deuxième points de connexion (P1, P2) sont toutes deux inférieures à la valeur de seuil du circuit de protection contre le disfonctionnement de verrouillage (22).

5. Circuit de décalage de niveau selon la revendication 1, **caractérisé en ce que**
le circuit de protection contre le disfonctionnement de verrouillage (22) comprend un élément inverseur (22a), un circuit série à transistors MOS à canal p où des premier et deuxième transistors MOS à canal p (PM1, PM2) sont connectés en série, et un circuit série à transistors MOS à canal n où des premier et deuxième transistors MOS à canal n (22d, 22e) sont connectés en série, dans lequel
le circuit série à transistors MOS à canal p et le circuit série à transistors MOS à canal n sont connectés en série entre la tension de source d'alimentation côté haute tension et la tension de source d'alimentation côté basse tension du système de tension côté secondaire (2, 2-1, 2-2),
le premier point de connexion (P1) est connecté aux grilles du premier transistor MOS à canal p (22c) et du premier transistor MOS à canal n (22d),
le deuxième point de connexion (P2) est connecté à la borne d'entrée de l'élément inverseur (22a),
la borne de sortie de l'élément inverseur (22a) est connectée aux grilles du deuxième transistor MOS à canal p (22c) et du deuxième transistor MOS à canal n (22e), et
un point de connexion du circuit série à transistors MOS à canal p et du circuit série à transistors MOS à canal n est connecté à la borne d'entrée de données du circuit de verrouillage (23).

6. Circuit de décalage de niveau selon la revendication 5, **caractérisé en ce que** la valeur de seuil du circuit de porte logique (OR1) est réglée pour être inférieure ou égale à la valeur de seuil du circuit de protection contre le disfonctionnement de verrouillage (22).

7. Circuit de décalage de niveau selon la revendication 4, **caractérisé en ce que** le circuit de verrouillage (23) est formé par un circuit tampon où une résistance (23c) est connectée entre le côté d'entrée et le côté de sortie.

8. Circuit de décalage de niveau selon la revendication 7, **caractérisé en ce que** le circuit tampon est formé par deux éléments inverseurs (23a, 23b) connectés en série.

9. Circuit de décalage de niveau selon la revendication 3, **caractérisé en ce qu'**il comprend en outre :
un troisième transistor MOS à canal p (PM1) connecté en parallèle à la première résistance (LSR1a) et un quatrième transistor MOS à canal p (PM2) connecté en parallèle à la deuxième résistance (LSR2a), dans lequel
la grille du troisième transistor MOS à canal p est connectée à un point de connexion de la deuxième résistance (LSR2a) et la quatrième résistance (LSR2b), et la grille du quatrième transistor MOS à canal p est connectée à un point de connexion de la première résistance (LSR1a) et la troisième résistance (LSR1b).

10. Circuit de décalage de niveau selon la revendication 9, **caractérisé en ce que**
le signal inversé du signal de sortie de circuit de verrouillage (23) a la tension de source d'alimentation côté basse tension du système de tension côté secondaire (2, 2-1, 2-2), et les rapports de division de tension de la première résistance (LSR1a) et la troisième résistance (LSR1b) sont fixés de manière à ce que la tension du premier point de connexion (P1), lorsque le premier élément de commutation (HVN1) et le troisième élément de commutation (PM1a) sont dans un état hors circuit, soit comprise entre une tension où la tension de valeur de seuil du quatrième transistor MOS à canal p (PM2) est soustraite de la tension de source d'alimentation côté haute tension du système de tension côté secondaire (2, 2-1, 2-2) et une tension où la tension de valeur de seuil du circuit de protection contre le disfonctionnement de verrouillage (22) par rapport à la tension du premier point de connexion (P1) est additionnée à la tension de source d'alimentation côté basse tension du système de tension côté secondaire (2, 2-1, 2-2), et
le signal non inversé du signal de sortie de circuit de verrouillage (23) a la tension de source d'alimentation côté basse tension du système de tension côté secondaire (2, 2-1, 2-2), et les rapports de division de tension de la deuxième résistance (LSR2a) et la quatrième résistance (LSR2b) sont fixés de manière à ce que la tension du deuxième point de connexion (P2), lorsque le deuxième élément de commutation (HVN2) et le quatrième élément de commutation (PM2a) sont dans un état hors circuit, soit comprise entre une tension où la tension de valeur de seuil du troisième transistor MOS à canal p (PM1) est soustraite de la tension de source d'alimentation côté haute tension du système d'alimentation côté secondaire (2, 2-1, 2-2) et une tension où la valeur de tension de seuil du circuit de protection contre le disfonctionnement de verrouillage (22) par rapport à la tension du deuxième point de connexion (P2) est additionnée à la tension de source d'alimentation côté basse tension du système de tension côté secondaire (2, 2-1, 2-2).
